# EUROPÄISCHE PATENTANMELDUNG

(11) **EP 2 429 264 A1**
(43) Veröffentlichungstag der Anmeldung: **14.03.2012**
(21) Anmeldenummer: 10176370.4
(22) Anmeldetag: 13.09.2010
(51) Int. Cl.: H05B 33/26, H05B 33/28, H03K 17/96

(54) **Schichtaufbau umfassend einen von einer ACPEL-Anordnung beleuchteten Schalter**

(71) Anmelder: Bayer MaterialScience AG, 51368 Leverkusen (DE)
(72) Erfinder: Kunz, Rainer, Dr., 51368 Leverkusen (DE); Bernert, Thomas, Dr., 51368 Leverkusen (DE); Hedderich, Wilfried, 51368 Leverkusen (DE)

(57) **Zusammenfassung**

Gegenstand der vorliegenden Erfindung ist ein Schichtaufbau, der mindestens einen von einer ACPEL-Anordnung (2) beleuchteten Schalter (4) umfasst, das Verfahren zur Herstellung und zur Verformung dieses Schichtaufbaus sowie dessen Verwendung zur Ausbildung von Anzeige- und Steuerelementen und zur Ausbildung von Gehäuseelementen für mobile oder stationäre Elektronikgeräte oder kleiner oder großer Haushaltsgeräte oder zur Ausbildung von Tastatursystemen ohne bewegliche Bauteile.

## Beschreibung

Gegenstand der vorliegenden Erfindung ist ein Schichtaufbau, der mindestens einen von einer ACPEL-Anordnung (ACPEL = alternating current powder electroluminnescence) beleuchteten Schalter umfasst, das Verfahren zur Herstellung und zur Verformung dieses Schichtaufbaus sowie dessen Verwendung zur Ausbildung von kleinen und großen Anzeige- und Steuerelementen und zur Ausbildung von Gehäuseelementen für mobile oder stationäre Elektronikgeräte oder kleiner oder großer Haushaltsgeräte oder zur Ausbildung von Tastatursystemen ohne bewegliche Bauteile.

Schalter weisen häufig eine Hintergrundbeleuchtung auf, die es ermöglicht, den Schalter beispielsweise in einem Hausflur oder an einer Vorrichtung, wie beispielsweise an einem Haushaltsgerät, auch bei Dunkelheit oder bei unzureichenden Beleuchtungsbedingungen zu finden und betätigen zu können. Darüber hinaus können entsprechende Beleuchtungen auch den Status des Schalters, wie den An-/Aus-Zustand, anzeigen.

Im Allgemeinen werden LEDs (LED = light emitting diode) oder ACPEL-Anordnungen als Lichtquellen für die Hintergrundbeleuchtung von Schaltern verwendet; weitere geläufige Bezeichnungen für ACPEL-Anordnungen sind: Elektrolumineszenz-Elemente, Elektrolumineszenz-Anordnungen oder Elektrolumineszenz-Vorrichtungen, wobei Elektrolumineszenz in der Regel mit EL abgekürzt wird.

Die Kombination aus Schalter und Hintergrundbeleuchtung wird häufig aus mindestens zwei getrennten Einheiten aufgebaut, wie beispielsweise aus einem mechanischen Schalter und entsprechenden LEDs oder einem mechanischen Schalter und ACPEL-Anordnungen.

Diese aus dem Stand der Technik bekannten Kombinationen von beleuchteten Schaltern aus getrennten Elementen weisen den Nachteil auf, dass ihre Bereitstellung teuer und aufgrund der Verwendung von mechanischen Bauteilen störungsempfindlich ist. Darüber hinaus treten weitere Nachteile auf, wie höheres Gewicht, eingeschränkte Form- und damit eingeschränkte Designfreiheit und eine große Einbautiefe.

Aus dem Stand der Technik sind außerdem Schichtaufbaue bekannt, bei denen nichtmechanische Schalter mit LEDs oder ACPEL-Anordnungen hinterleuchtet werden.

So offenbart W02008/131305A1 einen gedruckten kapazitiven Schalter, der von LEDs hinterleuchtet ist. US2005/0206623A1 offenbart einen kapazitiven Schalter, der von einer ACPEL-Anordnung hinterleuchtet ist. US2008/202912A1 offenbart einen von LEDs oder OLEDs (OLED = organic light emitting diode) hinterleuchteten kapazitiven Schalter.

ACPEL-Anordnungen sind häufig durch ein Druckverfahren erhältlich.

Diese Kombinationen von beleuchteten Schaltern haben den Vorteil gegenüber den beleuchteten Schaltern aus getrennten Elementen, dass sie keine mechanischen Bauteile besitzen, daher weniger störungsempfindlich sind, und ein niedrigeres Gewicht aufweisen. Außerdem bilden diese Kombinationen zumindest auf der dem Benutzer zugewandten Seite ununterbrochene Oberflächen. Solche Oberflächen sind zum einen leichter sauber zu halten und zum anderen vermitteln sie einen ästhetisch höherwertigen Eindruck.

Nachteilig bei den in den vorgenannten Schutzrechten offenbarten Kombinationen von beleuchteten Schaltern ist, dass sie nur flache oder leicht gebogene flächige Bauteile zur Verfügung stellen, oder dass zwar, wie im Falle der in W02008/131305A1 offenbarten Anordnung, der Schalter dreidimensional verformt ist, aber die Hinterleuchtung durch LEDs geschieht. Da diese LEDs nicht verformt werden können, ist die Hintergrundbeleuchtung des verformten Schalters nicht schattenfrei und gleichmäßig.

Seit WO03/037039A1 ist bekannt, dass ACPEL-Anordnungen nahezu beliebig dreidimensional verformt werden können. Diese Anordnungen dienen bisher aber nur dazu, dreidimensional verformte Anzeigen schattenfrei und gleichmäßig zu hinterleuchten. Diese Anzeigen weisen aber im Verformungsbereich außer der ACPEL-Anordnung keine weiteren elektrotechnischen Bauteile mehr auf.

Nicht aus dem Stand der Technik bekannt ist es, dreidimensional verformte elektrotechnische Bauteile, wie beispielsweise einen Schalter, mit einer gleichermaßen dreidimensional verformten ACPEL-Anordnung zu hinterleuchten.

Versuche solche Schalter zu bauen scheiterten bisher daran, dass es beim Verformen durch das Verstrecken und Stauchen der verschiedenen Schichten zur Delamination des Schichtaufbaus kam, die das gesamte Bauteil und damit auch seine Funktionsfähigkeit beschädigte.

Außerdem kam bei den aus dem Stand der Technik bekannten Schaltern zu einer Interferenz der ACPEL-Betriebsspannung mit dem Schaltsignal des Schalters. Dabei wird das Schaltsignal der Schalter durch die Wechselspannung, mit der die ACPEL-Anordnung betrieben wird, derart gestört, dass eine Detektion eines Schaltvorganges erschwert bzw. unmöglich wird.

Aufgabe der vorliegenden Erfindung ist es, einen Schichtaufbau zur Verfügung zu stellen, der mindestens eine Kombination aus Schalter und Hintergrundbeleuchtung aufweist, wobei sowohl der Schalter als auch die Hintergrundbeleuchtung auf ein und demselben Substrat aufgebracht sind und sowohl der Schalter als auch die Hintergrundbeleuchtung derart dreidimensional verformt sind, dass die Hintergrundbeleuchtung den Schalter gleichmäßig und schattenfrei hinterleuchtet. Außerdem soll es bei der Verformung nicht zu einer Delamination des Schichtaufbaus kommen. Auch soll es nicht zu einer Interferenz der ACPEL-Betriebsspannung mit dem Schaltsignal des Schalters kommen. Dieser Schichtaufbau soll durch ein einfaches Herstellverfahren erhältlich und in vielfältigen Anwendungen einsetzbar sein.

Die Aufgabe wird erfindungsgemäß durch einen Schichtaufbau umfassend einen Schalter und eine ACPEL-Anordnung, wobei der Schalter und die ACPEL-Anordnung aufeinander in beliebiger Reihenfolge auf derselben Seite desselben Substrats aufgebracht sind, wobei der Schalter eine Frontelektrode und eine Rückelektrode umfasst und wobei die ACPEL-Anordnung eine Frontelektrode und eine Rückelektrode umfasst,dadurch gelöst, dass der Schalter und die ACPEL-Anordnung jeweils dreidimensional verformt sind, wobei unabhängig voneinander die Rückelektrode der ACPEL-Anordnung und die Front- und die Rückelektrode des Schalters ein elektrisch leitfähiges Material enthalten ausgewählt aus der Gruppe bestehend aus einem intrinsisch leitfähigen Polymer und Silber, und die Frontelektrode der ACPEL-Anordnung ein intrinsisch leitfähiges Polymer enthält.

Weitere bevorzugte Ausführungsformen finden sich in den Unteransprüchen.

Damit eine optimale Haftung und Verformbarkeit des Schichtaufbaus gewährleistet ist, müssen die Schichten hinsichtlich ihrer chemischen Bestandteile und physikalischen Eigenschaften aufeinander angepasst sein. Dabei ist insbesondere die Auswahl des Materials der Elektroden der ACPEL-Anordnung und der Elek-troden des Schalters kritisch.

Hier wurde überraschenderweise gefunden, dass der Schichtaufbau auch eine starke Verformung übersteht, ohne dass es zur Delamination kommt oder die Funktionsfähigkeit verloren geht, wenn unabhängig voneinander die Rückelektrode der ACPEL-Anordnung und die Front- und die Rückelektrode des Schalters ein elektrisch leitfähiges Material enthalten ausgewählt aus der Gruppe bestehend aus intrinsisch leitfähigen Polymeren und Silber, und die Frontelektrode der ACPEL-Anordnung ein intrinsisch leitfähiges Polymer enthält.

Nach einer Ausgestaltung der Erfindung enthalten die Rückelektrode der ACPEL-Anordnung und die Front- und die Rückelektrode des Schalters unabhängig voneinander mindestens 20 Gew-%, bevorzugt mindestens 30 Gew.-%, besonders bevorzugt mindestens 40 Gew.-% eines intrinsisch leitfähigen Polymers oder mindestens 50 Gew.-%, bevorzugt mindestens 60 Gew.-% Silber; die Frontelektrode der ACPEL-Anordnung enthält mindestens 20 Gew-%, bevorzugt mindestens 30 Gew.-%, besonders bevorzugt mindestens 40 Gew.-% eines intrinsisch leitfähigen Polymers. Naturgemäß enthalten die Pasten oder andere Formulierungen zu Herstellung der Elektroden geringere Anteile an intrinsisch leitfähigen Polymeren bzw. Silber, da die Pasten oder Formulierungen große Teile an Lösemittel enthalten, die bei der weiteren Verarbeitung entweichen.

Intrinsisch leitfähige Polymere, die für den erfindungsgemäßen Schichtaufbau geeignet sind, sind beispielsweise PEDOT:PSS (Poly(3,4-ethylendioxythiophen) Poly(styrolsulfonat)), die beispielsweise von der H.C. Starck GmbH unter der Marke CLEVIOS und von der Agfa-Gevaert Group unter der Marke ORGACON vertrieben werden, oder Polyanillin, Polypyrrol oder Polythiophen, oder Mischungen aus diesen Polymeren.

Da eine erfindungsgemäß Silber enthaltende Elektrode im Gegensatz zu einer erfindungsgemäß intrinsisch leitfähige Polymere enthaltenden Elektrode nicht transparent ist, kann eine Silber enthaltende Elektrode für die Frontelektrode der ACPEL-Anordnung nicht verwendet werden, da durch eine Silber enthaltende Elektrode kein Licht abgestrahlt werden kann.

Im Sinne der vorliegenden Erfindung bedeutet transparent bezogen auf eine bestimmte Schicht, dass mindestens 50 %, bevorzugt mindestens 65 %, besonders bevorzugt mindestens 80 % des von der ACPEL-Anordnung in Richtung der Schicht abgestrahlten Lichtes durch diese Schicht hindurchtritt.

Schalter und ACPEL-Anordung können in beliebiger Reihenfolge auf dem Substrat aufgebracht sein, d.h. zuerst kann auf dem Substrat der Schalter aufgebracht sein und dann die ACPEL-Anordnung oder umgekehrt. Auch wenn zuerst die ACPEL-Anordnung auf dem Substrat aufgebracht ist und dann der Schalter, müssen die Elektroden des Schalters nicht notwendigerweise die intrinsisch leitfähigen Polymere enthalten. Vielmehr können die Elektroden des Schalters auch Silber enthalten, da die flächigen Abmessungen des Schalters meist geringer - in einigen Fällen weitaus geringer - sind als die flächigen Abmessungen der ACPEL-Anordnung. So kann der Schalter beispielsweise nur aus einer dünnen Linie von etwa 100 µm Linienbreite bestehen; zusätzlich kann der Schalter in Form eines Symbols ausgestaltet sein, dass beispielsweise auf die Funktion hinweist, die durch den Schalter geschaltet wird.

Alternativ oder zusätzlich kann der Schalter bzw. können die Konturen des Schalters von einer Grafikschicht abgedeckt sein, sofern eine solche vorhanden ist. Ist eine Grafikschicht vorhanden, liegt die ACPEL-Anordnung aus Sicht des Betrachters/Bedieners des erfindungsgemäßen Schichtaufbaus vorzugsweise hinter der Grafikschicht. Vorzugsweise liegt die Grafikschicht aus Sicht des Betrachters/Bedieners hinter dem Substrat ― unabhängig davon, ob zuerst auf dem Substrat der Schalter aufgebracht ist und dann die ACPEL-Anordnung oder umgekehrt ―, da die Grafikschicht dann vor Abtragen geschützt ist. Alternativ, wenn die Grafikschicht aus Sicht des Betrachters/Bedieners vor dem Substrat liegt, kann die Grafikschicht mit einer zusätzlichen Schutzschicht versehen sein. Die Grafikschicht ist nur in Teilen, also nicht vollflächig, lichtundurchlässig. Durch die Gestaltung der transparenten und lichtundurchlässigen Bereiche der Grafikschicht können dem Betrachter/Bediener des Schichtaufbaus Informationen zur Funktion des Schalters, des Schichtaufbaus und/oder eine ästhetische Darstellung gezeigt werden.

In einer vorzugsweisen Ausgestaltung der Erfindung besteht die Rückelektrode der ACPEL-Anordnung aus Silber, da dadurch das Licht der ACPEL-Anordung reflektiert wird, das nicht in Richtung des Betrachters/Bedieners abgestrahlt wird.

Um zu verhindern, dass es zu einer Interferenz der ACPEL-Betriebsspannung mit dem Schaltsignal des Schalters kommt, sind die Schichten der ACPEL-Anordnung von den Schichten des Schalters durch eine Isolationsschicht getrennt. Diese Isolationsschicht ist notwendigerweise dann transparent, wenn auf dem Substrat zuerst die ACPEL-Anordnung und darauf dann der Schalter aufgebracht sind. Wenn auf dem Substrat zuerst der Schalter und dann die ACPEL-Anordnung aufgebracht sind, kann die Isolationsschicht transparent sein, sie kann aber auch lichtundurchlässig sein.

Als Isolationsschicht sind beispielsweise Schichten aus polyurethan- oder polycarbonatbasierten Klarlacken geeignet, wie die kommerziell erhältlichen Isolationszusammensetzungen, die unter den Handelsnamen Noriphan HTR, Noriphan PCI Noriphan N2K, Noricryl und NoriPET von der Firma Pröll KG, Weißenburg in Bayern, Deutschland, oder unter dem Handelsnamen Maraflex FX, Ultraflex UVF oder Ultraform UVFM von der Firma Marabu GmbH & Co. KG, Tamm, Deutschland, oder unter dem Handelsnamen Polyplast PY von der Firma Fujifilm Sericol Deutschland GmbH vertrieben werden.

Die Dicke der Isolationsschicht beträgt dabei zwischen 20 und 100 µm, bevorzugt zwischen 30 und 80 µm, besonders bevorzugt zwischen 40 und 70 µm. Diese Isolationsschicht verhindert darüber hinaus einen elektrischen Kurzschluss zwischen dem Schalter und der ACPEL-Anordnung.

Bei dem Schalter kann es sich um einen kapazitiven oder auch um einen resistiven Schalter handelnDruckbare resistive Schalter sind aus EP1887595A1 und US6272936B1 bekannt.

Dieser Schichtaufbau weist als Vorteile auf, dass er keine mechanischen Bauteile besitzt, daher weniger störungsempfindlich ist, ein niedriges Gewicht aufweist und sehr dünn ist, auf der dem Benutzer zugewandten Seite eine ununterbrochene Oberfläche bildet, wodurch sie leichter sauber zu halten ist und einen ästhetisch höherwertigen Eindruck vermittelt, und der Schalter gleichmäßig und schattenfrei hinterleuchtet ist. Durch die dreidimensionale Verformung sowohl des Schalters als auch der ACPEL-Anordnung kann ein Bediener den Schalter sowohl sehen als auch fühlen.

Außerdem sind sowohl die ACPEL-Anordnung als auch der kapazitive Schalter des Schichtaufbaus einfach und kostengünstig durch ein Druckverfahren erhältlich.

Der erfindungsgemäße Schichtaufbau kann zur Ausbildung von kleinen und großen Anzeige- und Steuerelementen und zur Ausbildung von Gehäuseelementen für mobile oder stationäre Elektronikgeräte oder kleiner oder großer Haushaltsgeräte oder zur Ausbildung von Tastatursystemen ohne bewegliche Bauteile verwendet werden.

Wie bereits beschrieben, sind ACPEL-Anordnungen, auch dreidimesional verformte, bekannt. In der vorliegenden Erfindung werden bevorzugt solche ACPEL-Anordnungen verwendet, wie sie in der WO 2009/027387 A1 und der DE 10 2009 017669 A1 offenbart sind.

Wie ebenfalls bereits beschrieben, sind verformte kapazitive Schalter bekannt. In der vorliegenden Erfindung werden bevorzugt solche kapazitiven Schalter verwendet, die in WO2008/131305A1 offenbart sind.

Wie bereits dargelegt, ist es jedoch nicht bekannt, einen Schichtaufbau umfassend eine ACPEL-Anordnung zusammen mit einem Schalter zu verformen.

ACPEL-Anordnungen an und für sich können derart dreidimensional verformbar sein, dass die Krümmungsradien der verformten Bereiche kleiner als 2 mm, bevorzugt kleiner als 1 mm sind. Der Verformungswinkel kann dabei größer als 60°, bevorzugt größer als 75°, besonders bevorzugt größer als 90°, ganz besonders bevorzugt größer als 105° sein.Der erfindungsgemäße Schichtaufbau umfassend einen Schalter und eine ACPEL-Anordung ist derart dreidimensional verformbar, dass die Krümmungsradien, gemessen an der Innenseite der Krümmung des Substrats, in den verformten Bereichen kleiner als 7 mm, bevorzugt kleiner als 5 mm, besonders bevorzugt kleiner als 3 mm, ganz besonders bevorzugt kleiner als 1 mm sein können. Der Verformungswinkel kann dabei in den verformten Bereichen größer als 60°, bevorzugt größer als 75°, besonders bevorzugt größer als 90°, ganz besonders bevorzugt größer als 105° sein.

Eine dreidimensional Verformung im Sinne der vorliegenden Erfindung bezieht sich auf jedwede Verformung des Schichtaufbaus aus einer zweidimensionalen Ebene heraus, die im mathematischen Sinne also durch eine Linearkombination zweier linear unabhängiger Vektoren nicht mehr beschrieben werden kann. Hierbei nicht berücksichtigt werden die normalen, produktionsbedingten Unebenheiten der Oberfläche des Substrats, die in einer Größenordung von höchstens + / - ca. 20 µm vom Sollwert des Substrats liegen.

Dreidimensional verformt bedeutet insbesondere, dass Ein- oder Ausstülpungen in einer oder aus einer im Wesentlichen ebenen Fläche vorhanden sind, wobei die Ein- und Ausstülpungen beliebige Querschnitte aufweisen können, insbesondere rund, speziell kreisrund, mehreckig, insbesondere regelmäßig polygonal, oder auch torusförmig nach Art einen aus einer Flächer herausgedrückten Ringes sein können. "Dreidimensional verformt" bedeutet nicht nur, dass eine Fläche nur in einer Raumrichtung gebogen, geknickt oder gewellt wurde.

Sowohl die ACPEL-Anordnung, die Isolationsschicht als auch der kapazitive Schalter werden durch ein Druckverfahren, beispielsweise durch Siebdruck, Tiefdruck, Flexodruck, Gravurdruck, Digitaldruck, Ink-Jet-Druck oder ein anderes dem Fachmann bekanntes Druckverfahren, aufgebracht. Die Druckverfahren sind einfach zu handhaben und kostengünstig.

Die Verformung des Schichtaufbaus geschieht beispielsweise durch isostatische Hochdruckverformung (High Pressure Forming = HPF), wie sie in EP0371425A2 oder W02009/043539A2 offenbart ist. Auch ist eine Verformung durch Thermoforming, wie sie in US5932167A, US6210623B1 und US6257866B1 offenbart ist, ist möglich. Insbesondere Ein- und Ausstülpungen aus einer Fläche hinaus lassen sich zuverlässig und reproduzierbar mit dem HPF-Verfahren erreichen.

Daraus ergibt sich folgendes Verfahren zur Herstellung des erfindungsgemäßen Schichtaufbaus:
(a) Bereitstellen eines Substrats,
(b) Aufbringen der Schichten der ACPEL-Anordnung, einer Isolationsschicht und des Schalters durch ein Druckverfahren, wobei die Reihenfolge hier nicht festgelegt ist, und
(c) Verformung des Schichtaufbaus.

Der dreidimensional verformte Schichtaufbau kann mit einem Kunststoff hinterspritzt werden, wie auch bereits in EP0371425A2 und W02009/043539A2 offenbart.

Der erfindungsgemäße Schichtaufbau kann zur Ausbildung von kleinen und großen Anzeige- und Steuerelementen und zur Ausbildung von Gehäuseelementen für mobile oder stationäre Elektronikgeräte oder kleiner oder großer Haushaltsgeräte oder zur Ausbildung von Tastatursystemen ohne bewegliche Bauteile verwendet werden.

Im Folgenden wird die Erfindung anhand von einigen Ausführungsformen schematisch näher dargestellt; dabei sollen die erfindungswesentlichen Merkmale hervor gehoben werden, ohne die Erfindung darauf einzuschränken.

Es zeigen:

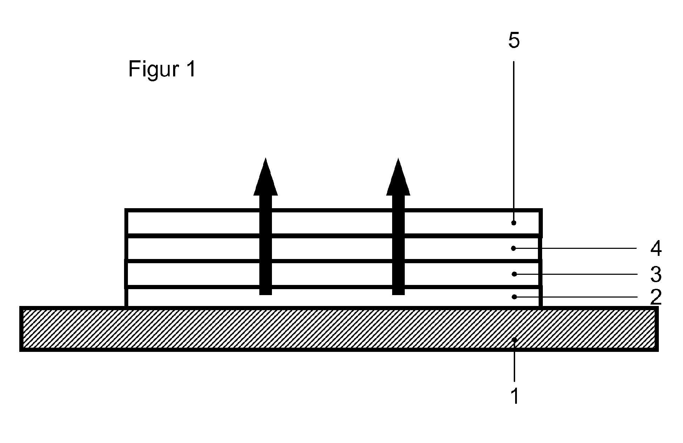

- Figur 1:: einen Schichtaufbau umfassend einen Schalter und eine ACPEL- Anordnung, wobei auf dem Substrat (1) zuerst eine ACPEL-Anordnung (2) und dann ein Schalter (4) aufgebracht ist. Zwischen der ACPEL-Anordnung (2) und dem Schalter (4) ist eine Isolationsschicht (3) aufgebracht. Auf der dem Substrat (1) abgewandten Seite der ACPEL-Anordnung (2) ist zusätzlich eine Grafikschicht (5) aufgebracht. Wie durch die Pfeile in Fig. 1 dargestellt, strahlt die ACPEL-Anordnung (2) Licht in Richtung der Grafikschicht (5) ab;

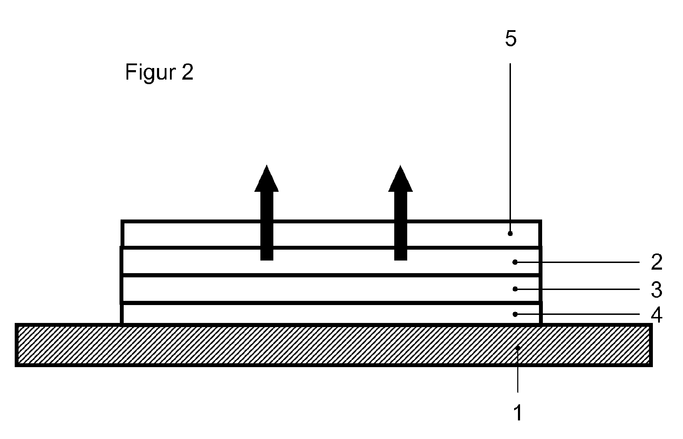

- Figur 2:: einen Schichtaufbau umfassend einen Schalter und eine ACPEL- Anordnung, wobei auf dem Substrat (1) zuerst ein Schalter (4) und dann eine ACPEL-Anordnung (2) aufgebracht ist. Zwischen dem Schalter (4) und der ACPEL-Anordnung (2) ist eine Isolationsschicht (3) aufgebracht. Auf der dem Substrat (1) abgewandten Seite der ACPEL-Anordnung (2) ist zusätzlich eine Grafikschicht (5) aufgebracht. Wie durch die Pfeile in Fig. 2 dargestellt, strahlt die ACPEL-Anordnung (2) wiederum Licht in Richtung der Grafikschicht (5) ab;

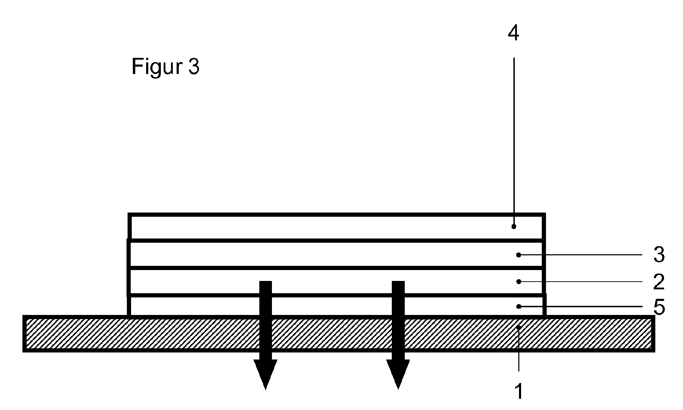

- Figur 3:: einen Schichtaufbau umfassend einen Schalter und eine ACPEL- Anordnung, wobei auf dem Substrat (1) zuerst eine Grafikschicht (5), dann eine ACPEL-Anordnung (2) und dann ein Schalter (4) aufgebracht ist. Zwischen dem Schalter (4) und der ACPEL-Anordnung (2) ist eine Isolationsschicht (3) aufgebracht. Die ACPEL-Anordnung (2) strahlt Licht in Richtung der Grafik (5) ab

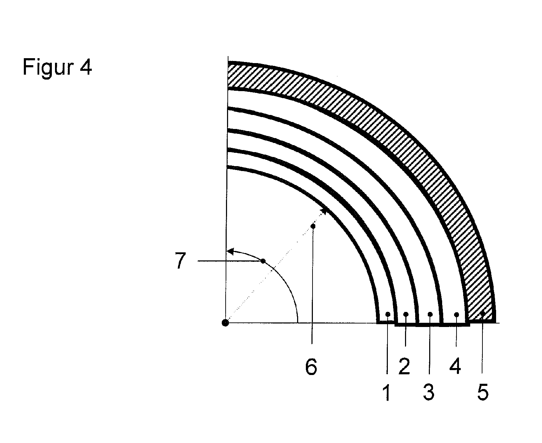

- Figur 4:: einen Schichtaufbau wie in Figur 1, wobei dieser dreidimensional verformt ist. Wie bereits beschrieben, wird der Krümmungsradius (6) an der Innenseite der Krümmung des Substrats abgenommen. Der Krümmungswinkel (7) ist ebenso dargestellt;

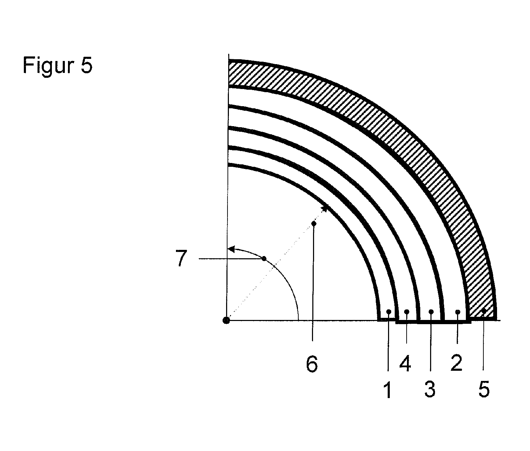

- Figur 5:: einen Schichtaufbau wie in Figur 2, wobei dieser dreidimensional verformt ist. Wie bereits beschrieben, wird der Krümmungsradius (6) an der Innenseite der Krümmung des Substrats abgenommen. Der Krümmungswinkel (7) ist ebenso dargestellt;

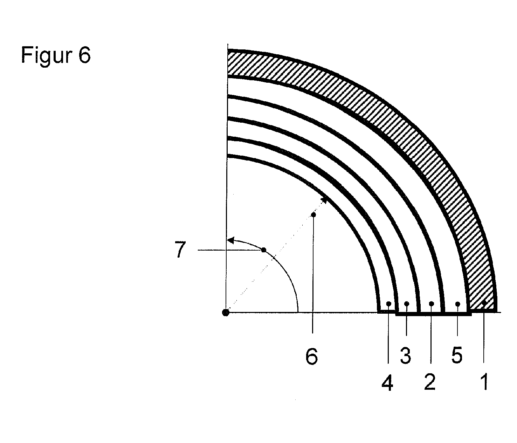

- Figur 6:: einen Schichtaufbau wie in Figur 3, wobei dieser dreidimensional verformt ist. Wie bereits beschrieben, wird der Krümmungsradius (6) an der Innenseite der Krümmung des Substrats abgenommen. Der Krümmungswinkel (7) ist ebenso dargestellt.

### Bezugszeichenliste:

- 2 =: 1 = Substrat ACPEL-Anordnung
- 3 =: Isolationsschicht
- 4 =: Schalter
- 5 =: Grafikschicht
- 6 =: Krümmungsradius
- 7 =: Verformungswinkel

## Patentansprüche

1. Schichtaufbau, umfassend einen Schalter (4) und eine ACPEL-Anordnung, (2) wobei der Schalter (1) und die ACPEL-Anordnung (2) aufeinander in beliebiger Reihenfolge auf derselben Seite desselben Substrats (1) aufgebracht sind, wobei der Schalter (4) eine Frontelektrode und eine Rückelektrode umfasst und wobei die ACPEL-Anordnung (2) eine Frontelektrode und eine Rückelektrode umfasst, **dadurch gekennzeichnet, dass** der Schalter (4) und die ACPEL-Anordnung (2) jeweils dreidimensional verformt sind, wobei unabhängig voneinander die Rückelektrode der ACPEL-Anordnung (2) und die Front- und die Rückelektrode des Schalters (4) ein elektrisch leitfähiges Material enthalten ausgewählt aus der Gruppe bestehend aus einem intrinsisch leitfähigen Polymer und Silber, und die Frontelektrode der ACPEL-Anordnung ein intrinsisch leitfähiges Polymer enthält.

2. Schichtaufbau nach Anspruch 1, **dadurch gekennzeichnet, dass** es sich bei dem Schalter (4) um einen kapazitiven oder einen resistiven Schalter (4) handelt.

3. Schichtaufbau nach Anspruch 1, **dadurch gekennzeichnet, dass** die Rückelektrode der ACPEL-Anordnung (2) und die Front- und die Rückelektrode des Schalters unabhängig voneinander mindestens 20 Gew-%, bevorzugt mindestens 30 Gew.-%, besonders bevorzugt mindestens 40 Gew.-% eines intrinsisch leitfähigen Polymers oder mindestens 50 Gew.-%, bevorzugt mindestens 60 Gew.-% Silber enthalten und die Frontelektrode der ACPEL-Anordnung (2) mindestens 20 Gew-%, bevorzugt mindestens 30 Gew.-%, besonders bevorzugt mindestens 40 Gew.-% eines intrinsisch leitfähigen Polymers enthält.

4. Schichtaufbau nach Anspruch 1, **dadurch gekennzeichnet, dass** das intrinsisch leitfähige Polymer ausgewählt ist aus der Gruppe bestehend aus PEDOT:PSS, Polyanillin, Polypyrrol und Polythiophen oder Mischungen aus diesen Polymeren.

5. Schichtaufbau nach Anspruch 1, **dadurch gekennzeichnet, dass** die Schichten der ACPEL-Anordnung (2) von den Schichten des Schalters (4) durch eine Isolationsschicht (3) getrennt sind.

6. Schichtaufbau nach Anspruch 5, **dadurch gekennzeichnet, dass** die Isolationsschicht (3) zwischen 20 und 100 µm, bevorzugt zwischen 30 und 80 µm, besonders bevorzugt zwischen 40 und 70 µm dick ist.

7. Schichtaufbau nach Anspruch 1, **dadurch gekennzeichnet, dass** die Krümmungsradien (6) in den verformten Bereichen kleiner als 7 mm, bevorzugt kleiner als 5 mm, besonders bevorzugt kleiner als 3 mm, ganz besonders bevorzugt kleiner als 1mm sind.

8. Schichtaufbau nach Anspruch 1, **dadurch gekennzeichnet, dass** der Verformungswinkel (7) in den verformten Bereichen größer als 60°, bevorzugt größer als 75°, besonders bevorzugt größer als 90°, insbesondere größer als 105° ist.

9. Verfahren zur Herstellung eines Schichtaufbaus nach Anspruch 1, umfassend folgende Schritte:
(a) Bereitstellen eines Substrats (1),
(b) Aufbringen der Schichten der ACPEL-Anordnung (2), einer Isolationsschicht und des Schalters (4) durch ein Druckverfahren,
(c) Verformung des Schichtaufbaus.

10. Verfahren nach Anspruch 9, **dadurch gekennzeichnet, dass** es sich bei dem Druckverfahren um Siebdruck handelt.

11. Verfahren nach Anspruch 9, **dadurch gekennzeichnet, dass** die Verformung durch isostatische Hochdruckverformung oder Thermoforming erfolgt.

12. Verfahren nach Anspruch 9, **dadurch gekennzeichnet, dass** der Schichtaufbau mit einem Kunststoff hinterspritzt wird.

13. Verwendung eines Schichtaufbaus nach Anspruch 1 zur Ausbildung von Anzeige- und Steuerelementen.

14. Verwendung eines Schichtaufbaus nach Anspruch 1 zur Ausbildung von Gehäuseelementen für mobile oder stationäre Elektronikgeräte oder kleiner oder großer Haushaltsgeräte oder zur Ausbildung von Tastatursystemen ohne bewegliche Bauteile.
